# DEMANDE DE BREVET EUROPEEN

(11) **EP 1 615 040 A1**
(43) Date de publication de la demande: **11.01.2006**
(21) Numéro de dépôt: 05291464.5
(22) Date de dépôt: 06.07.2005
(51) Int. Cl.: G01R 19/25, H02J 13/00

(54) **Procédé et installation pour l'identification d'évènements causant des perturbations sur un réseau électrique**

(30) Priorité: 09.07.2004 FR 0407715
(71) Demandeur: Electricité de France, 75008 Paris (FR)
(72) Inventeur: Gorgette, Frédéric, 94240 L'Hay Les Roses (FR); Schmaranz, Robert, 9020 Klagenfurt (AT)
(74) Mandataire: Hassine, Albert

(57) **Abrégé**

L'invention concerne la détection de perturbations sur un réseau électrique et l'identification d'évènements susceptibles d'avoir causé ces perturbations. On obtient des mesures de paramètres électriques caractérisant ces évènements. On construit un système, de type tableau (TAB), dont chaque case (Cᵢⱼ) représente un couple "*type d'évènement* (EVᵢ)/*paramètre mesuré* (PAⱼ)". Pour chaque case, on calcule un coefficient de probabilité pour qu'un type d'évènement soit la cause des perturbations, en fonction d'une comparaison entre le paramètre mesuré et une valeur de référence de ce paramètre, d'une part, et d'un degré de pertinence du paramètre pour caractériser l'évènement associé, d'autre part.

## Description

L'invention concerne la détection de perturbations sur un réseau électrique et l'identification d'un évènement susceptible d'avoir causé ces perturbations.

On connaît par les documents US-5,659,453, US-5,485,093, US-5,506,789 et US-5,578,931 des systèmes de détection de perturbations sur une ligne d'alimentation électrique. Ces différents systèmes mesurent des variations de paramètres électriques respectifs (par exemple le courant et la tension électrique dans US-5,659,453, l'énergie électrique dans US-5,485,093, la forme d'onde électrique dans US-5,506,789, le spectre de puissance dans US-5,578,931). Si ces paramètres mesurés s'écartent substantiellement de valeurs de référence respectives correspondant à des situations jugées normales, une alarme est simplement déclenchée. On ne propose pas, dans ces documents, de vérifier si cet écart entre valeur mesurée et valeur de référence est réellement causé par une défaillance du réseau. A plus forte raison, on ne propose pas non plus de déterminer l'événement ayant causé ces perturbations.

La présente invention vient améliorer la situation.

L'un des buts de la présente invention est de proposer un procédé pour identifier un évènement susceptible d'avoir causé des perturbations sur un réseau électrique.

Un autre but de la présente invention est de proposer un procédé pour classifier différents types d'évènements susceptibles d'avoir causé une perturbation sur un réseau électrique.

Elle propose à cet effet un procédé de détection de perturbations sur un réseau électrique et d'identification d'un évènement susceptible d'avoir causé ces perturbations, dans lequel :
a) on prévoit une pluralité de types d'évènements susceptibles de causer les perturbations sur le réseau électrique,
b) on obtient, en un point choisi du réseau, des mesures de paramètres électriques permettant de caractériser ces évènements,
c) on construit un système, de type tableau, dont chaque case représente un couple comportant un paramètre mesuré et un type d'évènement,
d) à chaque case du tableau, on affecte un coefficient représentant une probabilité pour qu'un type d'évènement associé à cette case soit la cause des perturbations, en fonction :
   - d'une comparaison du paramètre mesuré associé à ladite case, à une valeur de référence de ce paramètre,
   - et d'un degré de pertinence du paramètre mesuré pour caractériser l'évènement associé à ladite case, et
e) pour chaque type d'évènement, on estime une combinaison des coefficients de probabilité associés aux paramètres mesurés caractérisant ce type d'évènement, pour délivrer une liste de types d'évènements avec des coefficients de probabilité globaux respectivement associés.

On comprendra ainsi que, selon une caractéristique avantageuse de la présente invention, il est possible, après l'étape e), de classifier les types d'évènements en les rangeant par ordre de coefficients de probabilité globaux, croissants ou décroissants.

On peut déterminer ainsi la ou les causes les plus probables des perturbations constatées.

Dans un mode de réalisation préféré, on associe à chaque case du tableau un modèle de variation prédéterminé qui donne une première estimation d'un coefficient de probabilité en fonction de la comparaison entre le paramètre mesuré associé à cette case et sa valeur de référence.

On comprendra ainsi que l'on fixe initialement les modèles de variations possibles des coefficients de probabilité associés aux couples *"type d'évènement*/*paramètre mesuré".* La classification des différents types d'évènements susceptibles d'avoir causé des perturbations est sensiblement déterministe.

Par ailleurs, dans une réalisation préférée, on pondère la première estimation des coefficients de probabilité en fonction d'un degré de pertinence d'un paramètre mesuré par rapport à un type d'évènement correspondant dans un couple *"type d'évènement*/*paramètre mesuré".* Cette pondération peut être menée par simple application d'un coefficient de pondération aux premières estimations précitées, ou encore par application de fonctions de pondération dont des exemples sont donnés plus loin dans la description détaillée en référence aux dessins.

Par ailleurs, ces coefficients de pondération et/ou ces fonctions de pondération sont aussi prédéterminés et affectés initialement à chaque case du tableau, comme les modèles de variation de probabilité en fonction de la valeur des paramètres mesurés.

Selon une caractéristique avantageuse, il peut être prévu d'obtenir des informations sur des évènements constatés ayant causé des perturbations réelles. On ajuste ensuite, en fonction des évènements réellement constatés et des paramètres mesurés, les modèles précités de variation de probabilité et/ou les coefficients de pondération et/ou les fonctions de pondération, pour affiner a posteriori les modèles d'estimation des probabilités associés aux différents types d'évènements répertoriés.

Dans une réalisation pratique où le tableau précité est stocké dans une mémoire adressable, avec au moins une adresse mémoire par case, on comprendra que l'on peut mémoriser initialement les modèles précités de variation de probabilité et/ou les coefficients de pondération et/ou les fonctions de pondération, en correspondance des adresses mémoire des cases du tableau. En particulier, on peut stocker des instructions informatiques pour mettre en oeuvre l'application des modèles de variation de probabilité et/ou des fonctions de pondération.

De façon plus générale, la présente invention vise aussi un produit programme d'ordinateur, destiné à être stocké dans une mémoire d'une unité de traitement, ou sur un support mémoire amovible et destiné à coopérer avec un lecteur de ladite unité de traitement. En particulier, ce produit programme d'ordinateur comporte des instructions pour la mise en oeuvre de tout ou partie des étapes du procédé selon l'invention.

La présente invention vise aussi une installation pour la mise en oeuvre du procédé ci-avant et comportant en particulier :
- au moins un capteur pour obtenir des mesures de paramètres électriques en un point choisi d'un réseau électrique, ainsi qu'une interface pour recevoir un signal représentatif desdites mesures,
- une mémoire adressable pour construire un système, de type tableau, dont chaque case représente un couple comportant un paramètre mesuré et un type d'évènement possible sur le réseau électrique,
- un support mémoire pour stocker des instructions de produit programme d'ordinateur pour la mise en oeuvre de tout ou partie des étapes du procédé, et
- un processeur capable de coopérer avec ladite interface pour traiter des données tirées desdites mesures, et avec ladite mémoire, d'une part, et ledit support mémoire, d'autre part, pour mettre en oeuvre tout ou partie des étapes du procédé.

D'autres caractéristiques et avantages de l'invention apparaîtront à l'examen de la description détaillée ci-après, et des dessins annexés sur lesquels :
- la figure 1a représente schématiquement une installation pour la mise en oeuvre du procédé au sens de la présente invention ;
- la figure 1b représente une unité de traitement de cette installation, avec des moyens de lecture d'un produit programme d'ordinateur pour la mise en oeuvre de tout ou partie des étapes du procédé au sens de la présente invention ;
- la figure 2 représente les étapes principales du procédé au sens de la présente invention ;
- la figure 3a représente schématiquement un tableau dont les cases sont associées à un couple "*type d'événement*/*paramètre mesuré",* construit par la mise en oeuvre des premières étapes du procédé au sens de la présente invention ;
- la figure 3b représente ce tableau avec des valeurs des coefficients Cᵢⱼ associées à chaque case du tableau, ainsi que les coefficients de probabilité globaux associés au type d'évènement EVh ;
- la figure 4a représente les étapes principales permettant de déterminer les valeurs des coefficients du tableau ;
- la figure 4b représente la structure de la mémoire de l'unité de traitement de la figure 1b, dans une réalisation préférée ;
- les figures 5a, 5b et 5c représentent trois modèles de fonctions prédéterminés donnant une première estimation d'un coefficient de probabilité associé à une case du tableau, en fonction de la valeur prise par le paramètre mesuré qui est associé à cette case ; et
- la figure 6 représente schématiquement des fonctions de pondération de cette première estimation qui peuvent être appliquées à une case du tableau ou, conjointement, à plusieurs cases du tableau.

On se réfère tout d'abord à la figure la sur laquelle on a représenté une installation pour la mise en oeuvre du procédé au sens de la présente invention. Cette installation comporte au moins un capteur 1. Ce capteur 1 est capable de prélever, sur un réseau électrique R, des mesures instantanées de tension u(t) et d'intensité i(t) d'un courant électrique acheminé par le réseau R. Dans l'exemple décrit, le réseau R est un réseau de distribution d'un courant multiphasé, par exemple triphasé. Le courant distribué est par exemple alternatif et, dans une réalisation préférée, le capteur 1 est capable de relever des signaux en tension u(t) et en intensité i(t) sur une pluralité de cycles d'alternance.

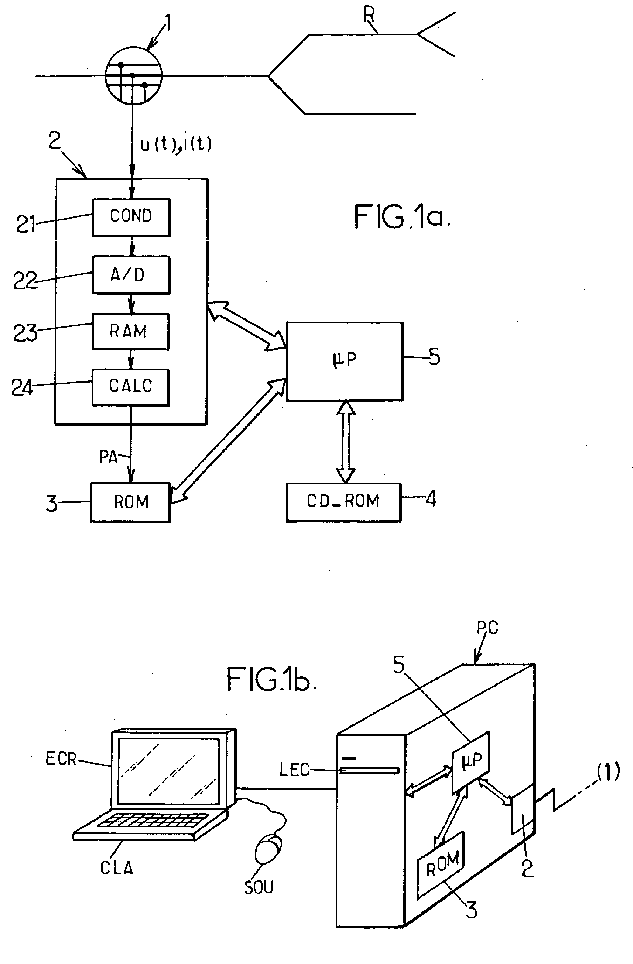

Ces signaux sont reçus par une interface 2 de l'installation. Cette interface 2 comporte un module 21 de filtrage et de mise en forme des signaux reçus. Ensuite, un module 22 convertit les signaux, reçus sous forme analogique, en signaux numériques, lesquels sont stockés dans une mémoire temporaire 23, par exemple de type RAM. Un module 24 calcule une pluralité de paramètres électriques PA dérivés de ces signaux numériques. On donne plus loin, à titre d'exemple, une liste de paramètres PA qui sont dérivés des mesures en tension et en intensité. En particulier, ces paramètres PA permettent de caractériser des évènements susceptibles de causer des perturbations dans le réseau R. Ces paramètres PA sont stockés ensuite dans une mémoire permanente 3, par exemple de type ROM, pour la construction d'un tableau selon le procédé de l'invention. On instruit les cases de ce tableau par le déroulement d'instructions informatiques que comporte un produit programme d'ordinateur pour la mise en oeuvre de tout ou partie des étapes du procédé selon l'invention. Ce produit programme d'ordinateur est, dans l'exemple décrit, stocké sur un support mémoire, par exemple de type CD-ROM (portant la référence 4 sur la figure 1a). Bien entendu, dans une variante, ce produit programme d'ordinateur peut être stocké dans la mémoire permanente 3, dans laquelle on construit le tableau précité. Les interactions entre les différents éléments de l'installation (l'interface 2, la mémoire permanente 3, la lecture du CD-ROM 4 par un lecteur approprié), sont gérées par un processeur 5, par exemple un microprocesseur d'une unité de traitement tel qu'un ordinateur classique.

En se référant à la figure 1b, on décrit maintenant cette unité de traitement PC. Elle comporte l'interface 2 qui reçoit les signaux émanant du capteur 1, ainsi que la mémoire permanente 3 et le processeur 5. L'unité de traitement PC comporte ici un lecteur LEC capable de lire le support mémoire sur lequel est stocké le produit programme d'ordinateur. De façon classique, l'unité de traitement comporte en outre des moyens de saisie, tels qu'un clavier CLA et une souris SOU, ainsi qu'un moniteur de visualisation ECR. L'unité de traitement peut comporter en outre une interface de communication avec un site distant, via un réseau de communication (non représentés).

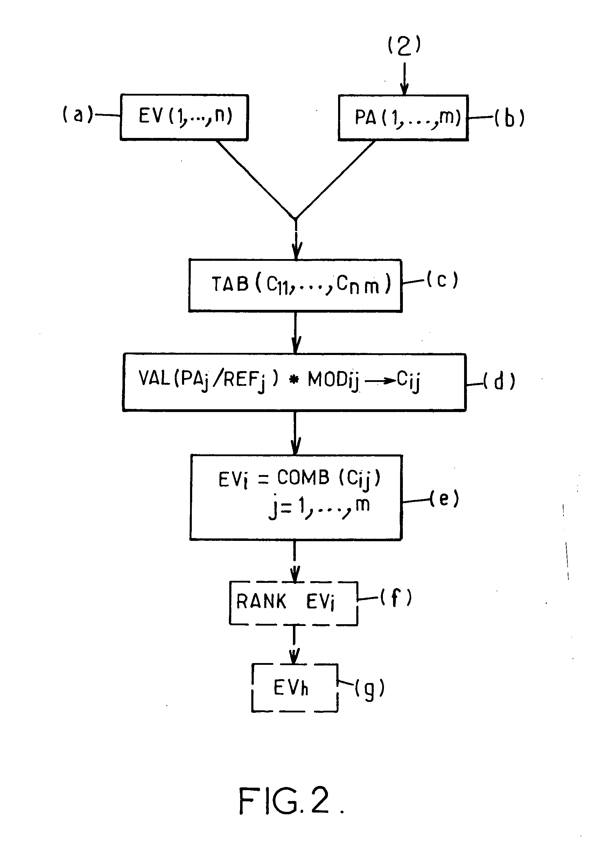

On se réfère maintenant à la figure 2 sur laquelle on a représenté les principales étapes du procédé dans un mode de réalisation préféré de la présente invention. A l'étape a), on prévoit n types d'événements EV qui sont susceptibles de causer des perturbations sur le réseau électrique R. A titre d'exemple, on peut citer des types d'évènements parmi au moins :
- un court-circuit entre phases du courant triphasé ;
- une ou plusieurs phases reliées à la terre ;
- une ou plusieurs phases déconnectées ;
- un effet capacitif dans le réseau (enclenchement de charge capacitive);
- un démarrage moteur ; et
- une mise sous tension d'un transformateur.

Par ailleurs, dans l'exemple où le réseau électrique R est un réseau de distribution, ce réseau peut comporter un transformateur d'alimentation. Typiquement, la mise à la terre accidentelle d'une ou plusieurs phases du courant, dans le réseau, peut présenter différents symptômes de perturbations selon un schéma donné de mise à la terre du neutre du transformateur. En effet, lors de la conception d'un réseau électrique, un schéma de liaison du neutre à la terre est choisi de sorte que le neutre peut être :
- soit isolé,
- soit relié intentionnellement à la terre, directement, par le biais d'une résistance ou d'une réactance.

Avantageusement, un mode de réalisation de la présente invention prévoit de distinguer ces différents cas de régime de neutre.

Par ailleurs, dans le procédé au sens de la présente invention, on a récupéré, à l'étape b), les paramètres électriques dérivés des mesures des signaux mis en forme par l'interface 2. Dans l'exemple représenté sur la figure 2, on prévoit m paramètres électrotechniques mesurés PA. A titre d'exemple, on indique que ces paramètres PA obtenus à partir des mesures en tension et en intensité peuvent être :
- une valeur efficace RMS (pour *"Root Mean Square"*) de la tension, pour chaque phase du courant triphasé et pour le neutre ;
- la valeur efficace RMS de l'intensité, pour chaque phase du courant triphasé et pour le neutre ;
- les trois phases du vecteur tension et les trois phases du vecteur intensité ;
- les trois vecteurs issus de la transformation des vecteurs simples en composantes de Fortescue pour la tension et l'intensité ;
- le taux de distorsion des harmoniques par rapport à la fréquence fondamentale (typiquement 50 Hz pour du courant alternatif en France), pour la tension et pour l'intensité ;
- la fréquence mesurée des alternances;
- la durée d'une perturbation (d'une chute de tension ou d'intensité, par exemple) ;
- la partie réelle et la partie imaginaire des impédances entre phases et entre les phases et le neutre ;
- la puissance active (réelle) et la puissance réactive (imaginaire pure) pour les trois phases ;
- le spectre de puissance ;
- un paramètre représentatif d'une perturbation en énergie et indicatif d'une provenance amont ou aval d'une perturbation ; et
- un paramètre indicatif d'une provenance amont ou aval d'une perturbation, basé sur une étude de l'impédance, soit entre phases, soit entre une ou plusieurs phases et la terre, selon le type d'événement.

On précise que ces deux derniers paramètres indiquent, de façon particulièrement avantageuse, une provenance amont ou aval d'une perturbation mesurée sur le réseau, par rapport au point où l'on capte les signaux de tension u(t) et d'intensité i(t). Par ailleurs, ces paramètres permettent aussi d'indiquer une production autonome d'électricité, en aval du point de mesure, outre l'électricité acheminée par le réseau.

On indique que la détection de la provenance amont ou aval d'une perturbation, en s'appuyant sur une perturbation en énergie, peut s'effectuer selon la méthode décrite notamment dans :
*"A direction find for power quality disturbancies based upon disturbance power and energy",* de A.C. PARSONS, W.M. GRADY, E.J. POWERS et J.C. SOWARD, dans IEEE Transactions on Power Delivery, vol.15, No.3, Juillet 2000.

Par ailleurs, dès lors qu'il est prévu de mesurer la durée d'une perturbation, on comprendra que le capteur 1 relève ses mesures pendant une durée prédéterminée.

A titre indicatif, on prévoit plus de quarante paramètres en tant qu'indicateurs caractérisant des évènements susceptibles d'entraîner des perturbations sur le réseau. Par ailleurs, on prévoit une trentaine de types d'évènements. On indique alors que ce nombre est doublé si l'on cherche à déterminer une provenance amont ou aval de la perturbation sur le réseau. En outre, ce nombre de types d'évènements est triplé si l'on souhaite aussi détecter une production autonome d'électricité en aval du réseau.

On comprendra ainsi que l'on doit instruire plus de 3000 cases du tableau que l'on construit, lorsqu'on cherche à classifier par ordre de probabilité les évènements qui sont susceptibles d'avoir causé une perturbation sur le réseau.

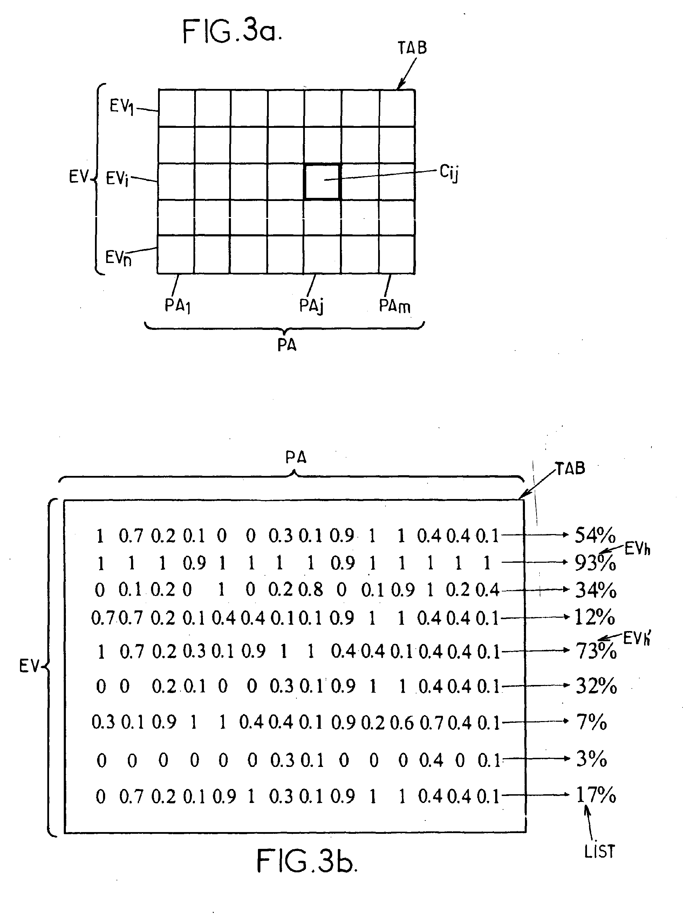

On se réfère à nouveau à la figure 2 pour décrire l'étape c), au cours de laquelle on construit ce tableau. On indique tout d'abord que ce tableau est représenté sur la figure 3a, de façon schématique. Par exemple, on peut affecter chaque ligne du tableau à un type d'évènement EVᵢ et affecter chaque colonne du tableau à un paramètre PAⱼ. Ainsi, le tableau comporte n x m cases. Chaque case Cᵢⱼ représente alors un couple "*type d'évènement EV*_{*i*}/*paramètre mesuré PA*_{*j*}".

A l'étape suivante d), on remplit les cases du tableau par des coefficients de probabilité associés à chaque case Cᵢⱼ du tableau. De façon générale, on indique qu'un coefficient de probabilité associé à une case Cᵢⱼ est fonction :
- d'une part, d'une valeur prise par le paramètre mesuré PAⱼ, par rapport à une valeur de référence REFⱼ de ce paramètre, et
- d'autre part, de la pertinence de ce paramètre PAⱼ pour caractériser l'évènement EVᵢ associé à cette case Cᵢⱼ.

On comprendra ainsi que l'on "*croise*" une valeur du paramètre mesuré (d'indice j) avec son degré de pertinence par rapport à l'évènement associé (d'indice i), pour instruire une case Cᵢⱼ du tableau.

Le calcul du coefficient de probabilité associé à cette case Cᵢⱼ est décrit plus loin de façon détaillée. Toutefois, de façon générale, on indique ici qu'il s'effectue en fonction de la valeur du paramètre mesuré et d'un modèle prédéterminé, associé à cette case Cᵢⱼ.

Le procédé se poursuit par l'étape e) dans laquelle on combine les estimations de probabilité des différentes cases Cᵢⱼ, avec j allant de 1 à m, pour déterminer un coefficient de probabilité global associé à l'évènement EVᵢ. Typiquement, on comprendra ainsi que l'on combine les coefficients des cases Cᵢⱼ d'une même ligne pour déterminer ce coefficient global, associé à un seul type d'évènement EVᵢ. La combinaison la plus simple de ces coefficients peut se faire par une simple moyenne sur toutes les cases. Toutefois, cette réalisation admet des variantes qui seront décrites plus loin.

En définitive, à l'issue de l'étape e), on obtient une liste LIST, telle que représentée dans l'exemple de la figure 3b, comportant les coefficients de probabilité globaux respectivement associés aux types d'évènements qui étaient prévus à l'étape a). Dans l'exemple représenté sur la figure 3b, on constate que l'on remplit chaque case du tableau avec une première estimation d'un coefficient de probabilité. Toutefois, ces coefficients de probabilité sont combinés, préférentiellement dans une même ligne, pour délivrer un coefficient de probabilité global associé à un évènement correspondant à cette même ligne. Typiquement, dans l'exemple représenté sur la figure 3b, l'évènement référencé EVh est le plus vraisemblable, par rapport aux autres évènements. Toutefois, il faut encore considérer l'évènement EVh' dont le coefficient de probabilité associé est relativement important.

Selon une caractéristique facultative, il peut être prévu, dans une étape ultérieure f), de classer et ranger par ordre de probabilité croissant ou décroissant ces différents évènements, typiquement pour faire apparaître les évènements les plus vraisemblables. Le procédé peut se poursuivre ensuite par une étape facultative g) dans laquelle on sélectionne l'évènement le plus vraisemblable, dont le coefficient de probabilité global est le plus élevé, parmi les autres évènements, pour expliquer la cause d'une perturbation constatée sur le réseau.

On indique en outre que les étapes a) à e) du procédé selon l'invention peuvent être menées de façon répétitive pour avoir plusieurs estimations successives dans le temps des probabilités associées aux évènements.

De façon avantageuse, on peut affiner les modèles MODᵢⱼ permettant de calculer les coefficients de probabilité des cases Cᵢⱼ, en fonction d'évènements réellement constatés sur le réseau, ce qui permet d'ajuster l'estimation des coefficients de probabilité globaux et la classification des évènements associés.

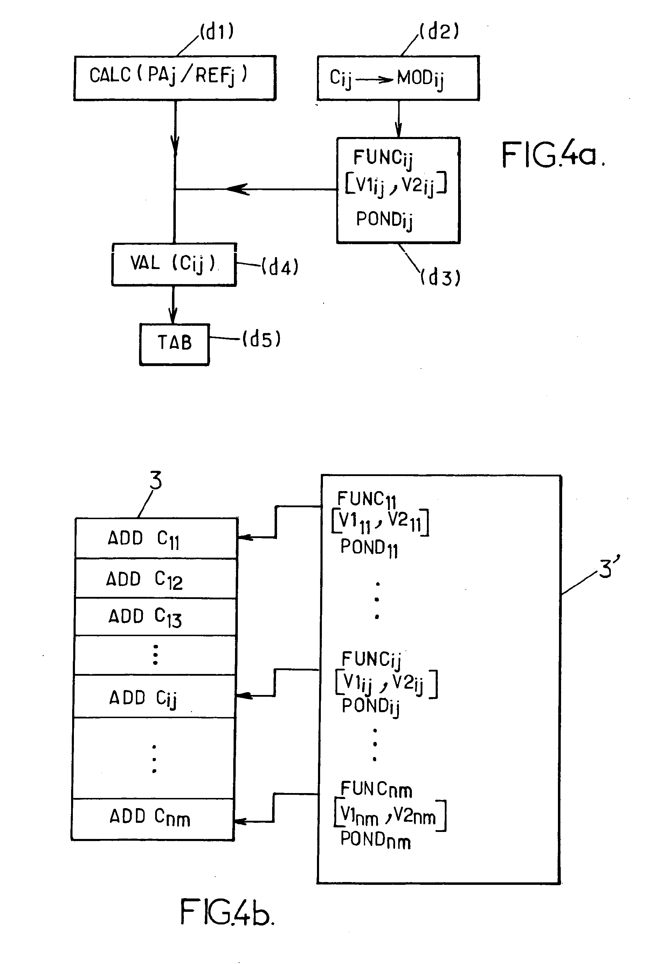

On se réfère maintenant à la figure 4a pour décrire l'estimation des coefficients affectés aux cases Cᵢⱼ du tableau.

A l'étape d1), on compare tout d'abord la valeur du paramètre mesuré PAⱼ à sa valeur de référence REFⱼ. Dans un exemple de réalisation non limitatif, cette comparaison consiste à calculer le rapport de la valeur du paramètre mesuré sur sa valeur de référence. Par exemple, si la tension nominale mesurée est de 440 volts, alors que sa valeur de référence devrait être de 400 volts, cette comparaison donne un rapport de 1,1.

Parallèlement à l'étape d1), en pointant sur la case Cᵢⱼ du tableau, on accède à un modèle MODᵢⱼ associé à cette case. Ce modèle MODᵢⱼ est caractérisé par :
- un modèle de variation prédéterminé FUNCᵢⱼ qui donne une première estimation d'un coefficient de probabilité, en fonction de la comparaison menée à l'étape d1), entre le paramètre mesuré et sa valeur de référence ;
- une plage de variation [V1ᵢⱼ,V2ᵢⱼ] de la fonction FUNCᵢⱼ, cette plage étant prédéterminée ; et
- un coefficient ou une fonction de pondération PONDᵢⱼ qui est aussi associé(e) à cette case.

On comprendra ainsi que le choix d'une case Cᵢⱼ, à l'étape d2), fait appel au contenu d'une mémoire comportant des instructions informatiques pour mettre en oeuvre le modèle MODᵢⱼ, à l'étape d3) de la figure 4a.

A l'étape suivante d4), on estime un coefficient de pondération à associer à la case Cᵢⱼ (noté *"val(C*_{*ij*}*) "* sur la figure 4a) en appliquant les caractéristiques du modèle MODᵢⱼ au rapport PAⱼ/REFⱼ. A l'étape d5), on mémorise cette valeur du coefficient de pondération dans la mémoire 3, qui, préférentiellement, est adressable comme on le verra en référence à la figure 4b.

Ainsi, on comprendra que :
- les modèles de variations FUNCᵢⱼ,
- les plages de valeurs [V1ᵢⱼ,V2ᵢⱼ], et
- les coefficients ou les fonctions de pondération PONDᵢⱼ, sont prédéterminés et affectés initialement à chaque case Cᵢⱼ du tableau TAB.

Sur la figure 4b, on a représenté la mémoire adressable 3. On a affecté à chaque case Cᵢⱼ du tableau TAB au moins une adresse ADDCᵢⱼ de cette mémoire 3. Par ailleurs, on a stocké dans la même mémoire 3 ou dans une mémoire différente 3', préférentiellement permanente, des instructions pour la mise en oeuvre des modèles MODᵢⱼ caractérisés par le modèle de variation FUNCᵢⱼ, par la plage de valeurs [V1ᵢⱼ, V2ᵢⱼ] et par la pondération PONDᵢⱼ, associés à la case Cᵢⱼ. En particulier, la mémoire 3' est aussi adressable de sorte que chaque appel d'adresse vers la mémoire 3 (stockant le tableau TAB) crée aussi un appel vers un jeu d'instructions de la mémoire 3' (stockant les modèles MODᵢⱼ).

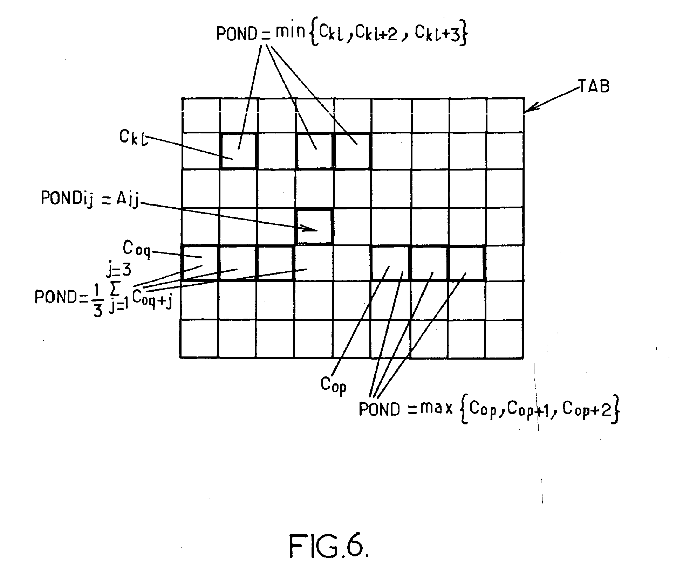

Ainsi, le tableau TAB est stocké dans la mémoire 3, adressable, avec au moins une adresse mémoire par case, tandis que l'on mémorise initialement, en correspondance des adresses mémoire des cases du tableau :
- des routines informatiques mettant en oeuvre les modèles de variation prédéterminés FUNCᵢⱼ,
- des valeurs prédéterminées de coefficients de pondération, pour une partie au moins des cases du tableau, comme on le verra en référence à la figure 6,
- et/ou des routines informatiques mettant en oeuvre des fonctions de pondération prédéterminées PONDᵢⱼ en correspondance de groupes d'adresses d'une partie au moins des cases du tableau, comme on le verra en référence à la figure 6.

On se réfère maintenant aux figures 5a à 5c pour décrire les modèles précités FUNCᵢⱼ, prédéterminés, de variation de la probabilité associée à une case Cᵢⱼ en fonction du rapport PAⱼ/REFⱼ. De façon générale, il s'agit de fonctions continues et comprenant au moins un premier palier et un second palier séparés par une phase non constante, de variation sensiblement monotone. Typiquement :
- si le type d'évènement associé à une case se caractérise par une décroissance de la valeur du paramètre mesuré par rapport à sa valeur de référence, par exemple un démarrage moteur entraînant une diminution de la valeur des tensions simples en dessous d'une valeur de référence, la phase précitée est décroissante, et
- si le type d'évènement associé à une case se caractérise au contraire par un accroissement de la valeur du paramètre mesuré par rapport à sa valeur de référence (par exemple une surtension au dessus d'une tension de référence), la phase est croissante.

On a représenté sur la figure 5a ce dernier cas. Globalement, le modèle FUNCᵢⱼ qui y est représenté comporte :
- un premier palier constant, de valeur limite basse en probabilité (0% dans l'exemple représenté),
- une phase croissante sur une plage [V1ᵢⱼ,V2ᵢⱼ] de valeurs prises par le paramètre mesuré par rapport à sa valeur de référence (linéairement croissante dans l'exemple représenté), et
- un second palier, constant, de valeur limite haute en probabilité (100% dans l'exemple représenté).

Dans l'exemple décrit, la plage [V1ᵢⱼ,V2ᵢⱼ] comporte des valeurs prises par le rapport PAⱼ/REFⱼ entre le paramètre mesuré PAⱼ et sa valeur de référence REFⱼ.

Ainsi, dans l'exemple d'une surtension avec une valeur mesurée de 440V par rapport à une valeur de référence de 400V, le rapport PAⱼ/REFⱼ vaut 1,1 et la première estimation de la probabilité associée à la case Cᵢⱼ est d'environ 50% dans l'exemple représenté sur la figure 5a. Cette valeur se déduit par interpolation sur la partie linéairement croissante du modèle FUNCᵢⱼ. En revanche, si la tension mesurée est de 520V, le rapport PAⱼ/REFⱼ vaut 1,3. Il est donc plus grand que la borne supérieure de la plage [V1ᵢⱼ, V2ᵢⱼ] qui vaut 1,2 dans l'exemple représenté. La première estimation de la probabilité associée à une tension mesurée de 520V sera donc de 100% pour cette case Cᵢⱼ. De même, si la tension mesurée est de 380V (donc inférieure à la tension de référence 400V), le rapport PAⱼ/REFⱼ est inférieur à 1 et donc plus petit que la borne inférieure de la plage [V1ᵢⱼ, V2ᵢⱼ]. Dans ce cas, la première estimation de la probabilité est de 0%.

Comme indiqué ci-avant, on affecte initialement ce modèle FUNCᵢⱼ, avant même de mesurer le paramètre PAⱼ, à une partie des cases du tableau si le type d'évènement associé à ces cases Cᵢⱼ se caractérise par un accroissement du paramètre mesuré PAⱼ par rapport à sa valeur de référence. De plus, on affecte initialement une plage de variation individuelle [V1ᵢⱼ,V2ᵢⱼ] à chaque case Cᵢⱼ .

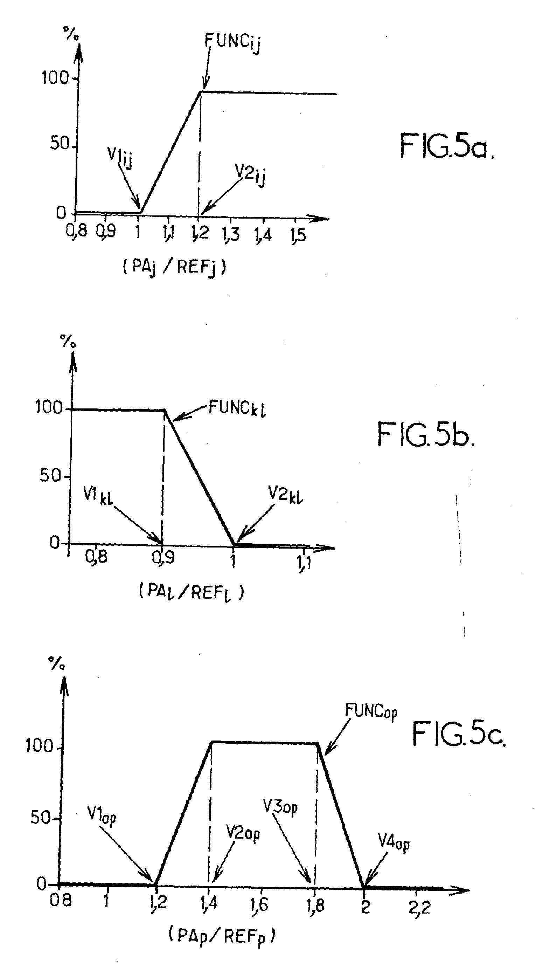

Au contraire, si le type d'évènement associé à d'autres cases Cₖₗ di tableau se caractérise par une décroissance du paramètre, on affectera plutôt le modèle FUNCₖₗ de la figure 5b, décrit ci-après, à ces autres cases.

En référence à la figure 5b, ce modèle FUNCₖₗ comprend :
- un premier palier constant, de valeur limite haute en probabilité (ici 100%),
- une phase décroissante, maintenant, sur la plage [V1ₖₗ,V2ₖₗ], et
- un second palier de valeur limite basse en probabilité (ici 0%).

En se référant maintenant à la figure 5c, on peut associer encore un troisième modèle de fonction FUNCₒₚ à d'autres cases Cₒₚ du tableau. Ce troisième modèle varie par rapport à ceux représentés sur les figures 5a et 5b en ce qu'il comporte :
- un premier palier constant, de valeur limite basse en probabilité (0% dans l'exemple),
- une phase croissante sur une première plage [V1ₒₚ,V2ₒₚ],
- un second palier de valeur limite haute en probabilité (par exemple 100%),
- une phase décroissante sur une seconde plage [V3ₒₚ,V4ₒₚ], et
- un troisième palier de valeur limite basse en probabilité (par exemple 0%).

Ce modèle convient typiquement pour un paramètre mesuré qui prend une valeur comprise sensiblement entre V1ₒₚ et V4ₒₚ pour un premier type d'évènement EVₒ, puis des valeurs par exemple supérieures à V4ₒₚ pour un second type d'évènement EV_{q} (l'indice q étant différent de l'indice o). Par exemple, pour un démarrage de moteur entraînant une légère chute de tension, on prévoit un modèle du type représenté sur la figure 5c. En revanche, pour une déconnexion due par exemple à la chute d'un arbre sur une ligne, on prévoit plutôt un modèle du type représenté sur la figure 5b, plus approprié pour une chute d'intensité substantielle.

Par exemple, les fronts montants et descendants du modèle de la figure 5c peuvent être choisis symétriques, de sorte que V4ₒₚ - V3ₒₚ = V2ₒₚ - V1ₒₚ.

On se réfère maintenant à la figure 6 pour décrire la combinaison précitée des premières estimations de probabilité calculées pour chaque case Cᵢⱼ d'une ligne (j=1 à m) pour donner une estimation globale d'une probabilité associée à un évènement EVᵢ.

Tout d'abord, on rappelle que cette combinaison comporte, dans une réalisation préférée, une pondération des premières estimations, ces premières estimations ayant été calculées au préalable pour chaque case à partir des modèles de variation FUNCᵢⱼ et des plages [V1ᵢⱼ,V2ᵢⱼ] comme décrit ci-avant.

On peut prévoir ici au moins trois types de fonctions de pondération. Avant de décrire ces types de fonctions, on indique qu'une étape préalable de construction de ces fonctions peut consister simplement à appliquer d'abord un coefficient de pondération Aᵢⱼ (figure 6), prédéterminé et indépendant de la valeur du paramètre mesuré, à une partie au moins des cases Cᵢⱼ du tableau. Typiquement, ce coefficient de pondération est variable entre 0 et 1. Par exemple, un coefficient Aᵢⱼ peut être de valeur nulle si le paramètre PAⱼ n'a pas à être pris en compte pour l'évènement EVᵢ. Ces coefficients de pondération sont donc représentatifs de degrés de pertinence des paramètres mesurés PAⱼ pour caractériser les évènements EVᵢ associés aux cases Cᵢⱼ. On affecte initialement, à tout ou partie des cases du tableau, des valeurs respectives prédéterminées de coefficients de pondération. Elles sont mémorisées par exemple dans la mémoire adressable 3' de la figure 4b.

Dans l'exemple représenté sur les figures 5a à 5c, les valeurs haute et basse des modèles de variation sont respectivement de 100% et de 0%. Toutefois, dans une variante, on comprendra que ces valeurs peuvent être différentes, par exemple respectivement égales à 75% et 0%, ou encore à 75% et 25%, notamment selon le type d'évènement à caractériser. Cette mesure permet d'introduire d'emblée une pondération de la première estimation de probabilités, obtenue à partir des modèles de variation des figures 5a à 5c.

Un premier type de fonction de pondération consiste à appliquer une moyenne des premières estimations calculées pour un groupe de cases C_{oq} à C_{oq+j} d'une même ligne d'indice o du tableau, comme représenté sur la figure 6. Eventuellement, cette moyenne peut être pondérée par les coefficients de pondération A_{oq} à A_{oq+j}, comme on l'a vu ci-avant. On affecte ensuite à chaque case du groupe C_{oq} à C_{oq+j} la valeur moyenne ainsi calculée. On indique qu'en variante d'une estimation de moyenne, l'estimation d'une médiane peut être prévue, par exemple.

Un second type de fonction de pondération qui peut être prévu consiste à affecter à toutes les cases d'un groupe de cases d'une même ligne la valeur maximum des premières estimations respectives des cases de ce groupe, le cas échéant pondérées par les coefficients de pondération Aᵢⱼ. En se référant à nouveau à la figure 6, on affecte à des cases d'une même ligne Cₒₚ à Cₒₚ₊ⱼ la valeur maximum "MAX" trouvée sur l'ensemble des premières estimations calculées respectivement pour ces cases. On remarquera, dans l'exemple de la figure 6, que certaines cases d'une même ligne peuvent être combinées par une fonction de pondération du premier type *"moyenne",* tandis que d'autres cases de la même ligne peuvent être combinées par une fonction de pondération d'un autre type, par exemple du second type "*MAX*".

Un troisième type de fonction de pondération qui peut être prévu consiste à affecter à toutes les cases d'un groupe de cases d'une même ligne la valeur minimum des premières estimations respectives des cases de ce groupe, le cas échéant pondérées par les coefficients de pondération Aᵢⱼ. En se référant à nouveau à la figure 6, on affecte à des cases d'une même ligne Cₖₗ à Cₖₗ₊ⱼ la valeur minimum *"min"* trouvée sur l'ensemble des premières estimations calculées respectivement pour ces cases.

Bien entendu, les fonctions de pondération peuvent aussi bien s'appliquer à des cases disjointes d'une même ligne (comme représenté pour la fonction *"min"* sur la figure 6) qu'à des cases successives (comme représenté pour les fonctions *"MAX"* et *"moyenne"* sur la figure 6).

On décrit maintenant un exemple d'une combinaison entre cases du tableau pour mener l'étape e) de la figure 2 décrite ci-avant.

Dans cet exemple, on distingue plusieurs classes de paramètres mesurés, selon leur degré de pertinence.

Pour les paramètres les plus significatifs d'évènements spécifiques, on applique la fonction de pondération *"min"* décrite ci-avant. Ce choix peut s'expliquer par le fait que plusieurs de ces paramètres ne sont pas réellement indépendants les uns des autres, par rapport aux évènements qu'ils caractérisent.

Pour des paramètres moins significatifs, une fonction de pondération de type *"moyenne"* est préférée. A cet effet, on prévoit une seconde classe de paramètres caractérisant des évènements spécifiques et dont les cases associées sont combinées entre elles par la fonction *"moyenne",* comme indiquée ci-avant.

On prévoit enfin une troisième classe caractérisant typiquement la provenance amont/aval d'une perturbation constatée sur le réseau et/ou caractérisant une production autonome d'électricité en aval du réseau. Typiquement, pour les évènements qui ont lieu en amont du réseau, si les paramètres décrits ci-avant et caractérisant la provenance indiquent une provenance amont, la probabilité affectée à cette troisième classe de paramètres sera par exemple de 100%. Dans ce même exemple, elle sera en revanche de 0% pour les types d'évènements qui concernent des perturbations en aval. Si les valeurs de paramètres indiquant la provenance sont incohérentes entre elles, on affecte par défaut une valeur de 100% à la fois aux évènements en amont et aux évènements en aval, un traitement ultérieur étant prévu pour affiner les estimations sur des cycles de mesure ultérieurs.

La combinaison des cases d'une même ligne du tableau TAB, pour un évènement particulier, s'effectue comme suit : EV[h]=(a.IC1+b.IC2).IC3/100, où :
- IC1 correspond à la première classe précitée, à laquelle on appliqué la fonction *"min" ;*
- IC2 correspond à la seconde classe précitée, à laquelle on applique la fonction *"moyenne" ;*
- IC3 correspond à la troisième classe précitée représentant la provenance amont ou aval d'une perturbation; et,
- EV[h] correspond à la probabilité globale calculée pour un type d'évènement donné.

Les essais menés ont révélé que les coefficients a et b, respectivement proches de 0,7 et 0,3 donnaient de bons résultats d'estimation des probabilités associées aux différents types d'évènements.

Bien entendu, la présente invention ne se limite pas à la forme de réalisation décrite ci-avant à titre d'exemple ; elle s'étend à d'autres variantes.

Ainsi, on comprendra que le calcul du rapport entre le paramètre mesuré et sa valeur de référence, décrit ci-avant, n'est qu'un exemple de comparaison entre le paramètre mesuré et cette valeur de référence. Par ailleurs, les plages prédéterminées pour les modèles de fonctions décrites en référence aux figures 5a à 5c peuvent être définies par des valeurs limites de ce paramètre, plutôt que par des valeurs limites du rapport de ce paramètre par rapport à sa valeur de référence.

On a décrit ci-avant des modèles de fonction en référence aux figures 5a à 5c qui comportent des phases monotones, linéaires. Bien entendu ce choix est susceptible de variante. Typiquement, il peut être prévu des fonctions asymptotiques, par exemple des exponentielles négatives.

Bien entendu, les paramètres mesurés et les types d'évènements répertoriés sont décrits ci-avant à titre d'exemple.

## Revendications

1. Procédé de détection de perturbations sur un réseau électrique et d'identification d'un évènement susceptible d'avoir causé ces perturbations, dans lequel :
a) on prévoit une pluralité de types d'évènements susceptibles de causer des perturbations sur un réseau électrique,
b) on obtient, en un point choisi du réseau, des mesures de paramètres électriques permettant de caractériser ces évènements,
c) on construit un système, de type tableau, dont chaque case représente un couple comportant un paramètre mesuré et un type d'évènement,
d) à chaque case du tableau, on estime un coefficient représentant une probabilité pour qu'un type d'évènement associé à cette case soit la cause des perturbations, en fonction :
- d'une comparaison du paramètre mesuré associé à ladite case, à une valeur de référence de ce paramètre,
- et d'un degré de pertinence du paramètre mesuré pour caractériser l'évènement associé à ladite case, et
e) pour chaque type d'évènement, on estime une combinaison des coefficients de probabilité associés aux paramètres mesurés caractérisant ce type d'évènement, pour délivrer une liste de types d'évènements avec des coefficients de probabilité globaux respectivement associés.

2. Procédé selon la revendication 1, dans lequel, à chaque case du tableau, est associé un modèle de variation prédéterminé donnant une première estimation d'un coefficient de probabilité en fonction de la comparaison entre le paramètre mesuré associé à cette case et sa valeur de référence.

3. Procédé selon l'une des revendications 1 et 2, dans lequel ladite comparaison comporte l'estimation d'un rapport de la valeur du paramètre mesuré sur ladite valeur de référence.

4. Procédé selon l'une des revendications 2 et 3, dans lequel lesdits modèles de variation prédéterminés associés aux cases sont des fonctions continues du type comprenant au moins un premier palier et un second palier séparés par une phase non constante, de variation sensiblement monotone.

5. Procédé selon la revendication 4, dans lequel :
- si le type d'événement associé à une case se **caractérise par** un accroissement de la valeur du paramètre mesuré par rapport à sa valeur de référence, ladite phase sensiblement monotone est croissante, et
- si le type d'événement associé à une case se **caractérise par** une décroissance de la valeur du paramètre mesuré par rapport à sa valeur de référence, ladite phase sensiblement monotone est décroissante.

6. Procédé selon l'une des revendications 4 et 5, dans lequel on associe à une partie des cases du tableau un modèle, comprenant :
- un premier palier constant, de valeur limite basse en probabilité,
- une phase croissante sur une plage de valeurs prises par le paramètre mesuré par rapport à sa valeur de référence, et
- un second palier de valeur limite haute en probabilité.

7. Procédé selon l'une des revendications 4 et 5, dans lequel on associe à une partie des cases du tableau un modèle, comprenant :
- un premier palier constant, de valeur limite haute en probabilité,
- une phase décroissante sur une plage de valeurs prises par le paramètre mesuré par rapport à sa valeur de référence, et
- un second palier de valeur limite basse en probabilité.

8. Procédé selon l'une des revendications 4 et 5, dans lequel on associe à une partie des cases du tableau un modèle, comprenant :
- un premier palier constant, de valeur limite basse en probabilité,
- une phase croissante sur une première plage de valeurs prises par le paramètre mesuré par rapport à sa valeur de référence,
- un second palier de valeur limite haute en probabilité,
- une phase décroissante sur une seconde plage de valeurs prises par le paramètre mesuré par rapport à sa valeur de référence, et
- un troisième palier de valeur limite basse en probabilité.

9. Procédé selon l'une des revendications 6 à 8, prises en combinaison avec la revendication 3, dans lequel lesdites plages comportent des valeurs prises par le rapport entre le paramètre mesuré et sa valeur de référence.

10. Procédé selon l'une des revendications 6 à 9, dans lequel lesdites plages de valeurs sont prédéterminées, et l'on affecte initialement, à chaque case du tableau, outre un modèle de variation prédéterminé, au moins une plage prédéterminée.

11. Procédé selon la revendication 10, dans lequel ledit tableau est stocké dans une mémoire adressable, avec au moins une adresse mémoire par case,
et dans lequel on mémorise initialement lesdites plages prédéterminées en correspondance des adresses mémoire des cases du tableau.

12. Procédé selon l'une des revendications 2 à 11, dans lequel ledit tableau est stocké dans une mémoire adressable, avec au moins une adresse mémoire par case,
et dans lequel on mémorise initialement des routines informatiques mettant en oeuvre lesdits modèles de variation prédéterminés, en correspondance des adresses mémoire des cases du tableau.

13. Procédé selon la revendication 12, prise en combinaison avec la revendication 10, dans lequel les modèles de variation, avec les plages de valeurs, sont construits en correspondance de chaque case du tableau, préalablement à l'étape d), et indépendamment des valeurs prises par le paramètre mesuré.

14. Procédé selon l'une des revendications 2 à 13, dans lequel on applique, auxdites premières estimations, des fonctions de pondération représentatives de degrés de pertinence des paramètres mesurés pour caractériser les évènements respectivement associés aux cases,
et dans lequel on affecte initialement, à chaque case du tableau, une fonction de pondération prédéterminée, indépendamment des valeurs prises par le paramètre mesuré et de la comparaison menée à l'étape d).

15. Procédé selon la revendication 14, dans lequel une partie au moins des fonctions de pondération comporte l'application de coefficients de pondération à une partie au moins desdites premières estimations.

16. Procédé selon la revendication 15, dans lequel ledit tableau est stocké dans une mémoire adressable, avec au moins une adresse mémoire par case,
et dans lequel on mémorise initialement les valeurs prédéterminées de coefficients de pondération, en correspondance d'une partie au moins des adresses mémoire des cases du tableau.

17. Procédé selon l'une des revendications 14 à 16, dans lequel on affecte initialement, à des groupes de cases du tableau correspondant à un même type d'évènement par groupe, des fonctions de pondération respectives, parmi au moins :
- une fonction qui, à un groupe de cases, affecte à toutes les cases du groupe, en tant que coefficient de probabilité, la valeur minimum des premières estimations respectives associées aux cases du groupe,
- une fonction qui, à un groupe de cases, affecte à toutes les cases du groupe, en tant que coefficient de probabilité, la valeur maximum des premières estimations respectives associées aux cases du groupe,
- une fonction qui, à un groupe de cases, affecte à toutes les cases du groupe, en tant que coefficient de probabilité, la valeur moyenne des premières estimations respectives associées aux cases du groupe.

18. Procédé selon la revendication 17, dans lequel ledit tableau est stocké dans une mémoire adressablé, avec au moins une adresse mémoire par case,
et dans lequel on mémorise initialement des routines informatiques mettant en oeuvre lesdites fonctions prédéterminées, en correspondance de groupes d'adresses d'une partie au moins des cases du tableau.

19. Procédé selon l'une des revendications 2 à 18, dans lequel on obtient des informations sur des évènements constatés ayant causé des perturbations réelles, et l'on ajuste, en fonction des évènements constatés et des paramètres mesurés, lesdits modèles et/ou lesdites plages prédéterminées et/ou lesdits coefficients de pondération et/ou lesdites fonctions respectives prédéterminées, associés aux cases du tableau.

20. Procédé selon l'une des revendications précédentes, dans lequel l'un au moins des paramètres mesurés est indicateur d'une localisation amont ou aval des évènements, par rapport audit point choisi du réseau électrique.

21. Procédé selon l'une des revendications précédentes, dans lequel l'un au moins des paramètres mesurés est indicateur d'une production autonome d'électricité, en aval du point de mesure, outre l'électricité acheminée par le réseau.

22. Procédé selon l'une des revendications précédentes, dans lequel le réseau achemine un courant multiphasé,
et dans lequel les types d'évènements sont parmi au moins :
- un court-circuit entre phases,
- une ou plusieurs phases reliées à la terre,
- une ou plusieurs phases déconnectées,
- un effet capacitif,
- un démarrage moteur, et
- une mise sous tension de transformateur.

23. Procédé selon l'une des revendications précédentes, dans lequel, après l'étape e), on classifie les types d'évènements en les rangeant par ordre de coefficients de probabilité globaux, croissants ou décroissants.

24. Installation pour la mise en oeuvre du procédé selon l'une des revendications précédentes, **caractérisée en ce qu'**elle comporte :
- au moins un capteur pour obtenir des mesures de paramètres électriques en un point choisi d'un réseau électrique, ainsi qu'une interface pour recevoir un signal représentatif desdites mesures,
- une mémoire adressable pour construire un système, de type tableau, dont chaque case représente un couple comportant un paramètre mesuré et un type d'évènement possible sur le réseau électrique,
- un support mémoire pour stocker des instructions de produit programme d'ordinateur pour la mise en oeuvre de tout ou partie des étapes du procédé selon l'une des revendications précédentes, et
- un processeur capable de coopérer avec ladite interface pour traiter des données tirées desdites mesures, et avec ladite mémoire, d'une part, et ledit support mémoire, d'autre part, pour mettre en oeuvre tout ou partie des étapes du procédé selon l'une des revendications précédentes.

25. Installation selon la revendication 24, **caractérisée en ce que** ladite mémoire et ledit support mémoire font partie d'une même mémoire, de type ROM.

26. Produit programme d'ordinateur, destiné à être stocké dans une mémoire d'une unité de traitement, ou sur un support mémoire amovible et destiné à coopérer avec un lecteur de ladite unité de traitement, **caractérisé en ce qu'**il comporte des instructions pour la mise en oeuvre de tout ou partie des étapes du procédé selon l'une des revendications 1 à 23.
